# FASCICULE DE BREVET EUROPEEN

(11) **EP 2 954 028 B1**
(45) Date de publication et mention de la délivrance du brevet: **11.07.2018**
(21) Numéro de dépôt: 14711287.4
(22) Date de dépôt: 07.02.2014
(51) Int. Cl.: C09K 11/06, C09G 1/12, H01B 1/00, H01L 51/00

(54) **NOUVEAUX METALLOPOLYMERES ET LEUR UTILISATION**
NEUARTIGE METALLPOLYMERE UND VERWENDUNG DAVON
NOVEL METALLOPOLYMERS AND USE THEREOF

(30) Priorité: 07.02.2013 FR 1351073
(43) Date de publication de la demande: 16.12.2015
(73) Titulaire: Commissariat à l'Énergie Atomique et aux Énergies Alternatives, 75015 Paris (FR); Centre National de la Recherche Scientifique (C.N.R.S.), 75794 Paris Cedex 16 (FR); Ecole Polytechnique, 91120 Palaiseau (FR)
(72) Inventeur: SERGENT, Alessandra, F-92800 Puteaux (FR); ZUCCHI, Gaël, F-91190 Gif Sur Yvette (FR); TONDELIER, Denis, F-91300 Massy (FR); GEFFROY, Bernard, F-94240 L'hay Les Roses (FR)
(74) Mandataire: Cabinet Plasseraud
(86) Numéro de dépôt international: PCT/FR2014/050234
(87) Numéro de publication internationale: WO 2014/122406

(56) Documents cités:
- WO-A1-2004/113468
- WO-A2-2004/070772
- ZHANG ET AL: "Synthesis and electroluminescent properties of a carbozole-functionalized europium(III) complex", JOURNAL OF LUMINESCENCE, ELSEVIER BV NORTH-HOLLAND, NL, vol. 126, no. 2, 17 mai 2007 (2007-05-17), pages 682-686, XP022082786, ISSN: 0022-2313, DOI: 10.1016/J.JLUMIN.2006.10.025
- DU ET AL: "Novel chemosensory materials based on polyfluorenes with 2-(2'-pyridyl)-benzimidazole and 5-methyl-3-(pyridin-2-yl)-1,2,4-triazole groups in the side chain", POLYMER, ELSEVIER SCIENCE PUBLISHERS B.V, GB, vol. 48, no. 5, 16 février 2007 (2007-02-16), pages 1245-1254, XP005892688, ISSN: 0032-3861, DOI: 10.1016/J.POLYMER.2007.01.011
- SHU-JUAN LIU ET AL: "Conjugated polymers with cationic iridium(iii) complexes in the side-chain for flash memory devices utilizing switchable through-space charge transfer", JOURNAL OF MATERIALS CHEMISTRY, vol. 22, no. 43, 1 janvier 2012 (2012-01-01), page 22964, XP055074322, ISSN: 0959-9428, DOI: 10.1039/c2jm31963b
- KEZHI WANG ET AL: "Optical properties of the highly ordered Langmuir-Blodgett film of a strongly luminescent Eu(III) complex", JOURNAL OF PHOTOCHEMISTRY AND PHOTOBIOLOGY A: CHEMISTRY, vol. 156, no. 1-3, 1 mars 2003 (2003-03-01), pages 39-43, XP055074261, ISSN: 1010-6030, DOI: 10.1016/S1010-6030(02)00437-9
- LILI CHEN ET AL: "Red- and white-emitting organic light-emitting diodes based on trimetallic dendritic europium (III) complex: Eu3(DBM)9(TMMB)", SOLID-STATE ELECTRONICS, vol. 69, 1 mars 2012 (2012-03-01), pages 67-71, XP055074266, ISSN: 0038-1101, DOI: 10.1016/j.sse.2011.12.005
- WANG K ET AL: "AN ALKYLATED EUROPIUM(III) COMPLEX FOR PHOTOELECTRIC DEVICES", SOLID STATE COMMUNICATIONS, PERGAMON, GB, vol. 122, no. 3/04, 1 janvier 2002 (2002-01-01), pages 233-236, XP008043906, ISSN: 0038-1098, DOI: 10.1016/S0038-1098(02)00082-0
- ZHANG ET AL: "Synthesis and photovoltaic properties of new europium complex Eu(DBM)3(CPyBM)", CHINESE CHEMICAL LETTERS, ELSEVIER LTD, GB, vol. 18, no. 3, 23 février 2007 (2007-02-23), pages 333-336, XP005943360, ISSN: 1001-8417, DOI: 10.1016/J.CCLET.2007.01.026
- DU BIN ET AL: "High-efficiency electrophosphorescent copolymers containing charged iridium complexes in the side chains", CHEMISTRY - A EUROPEAN JOURNAL, WILEY - V C H VERLAG GMBH & CO. KGAA, WEINHEIM, DE , vol. 13, no. 26 1 janvier 2007 (2007-01-01), pages 7432-7442, XP008164024, ISSN: 0947-6539, DOI: 10.1002/CHEM.200601811 Extrait de l'Internet: URL:http://www3.interscience.wiley.com/cgi -bin/issn?DESCRIPTOR=PRINTISSN&VALUE=0947- 6539 [extrait le 2007-06-21]

## Description

La présente invention concerne de nouveaux métallopolymères, leur préparation ainsi que leur utilisation dans des diodes électroluminescentes.

Les diodes électroluminescentes organiques (OLED de l'anglais : organic light emitting diode) ont connu un grand succès depuis leur mise sur le marché vers la fin des années 1990. Aujourd'hui, elles sont de plus en plus utilisées pour des dispositifs du domaine de l'affichage.

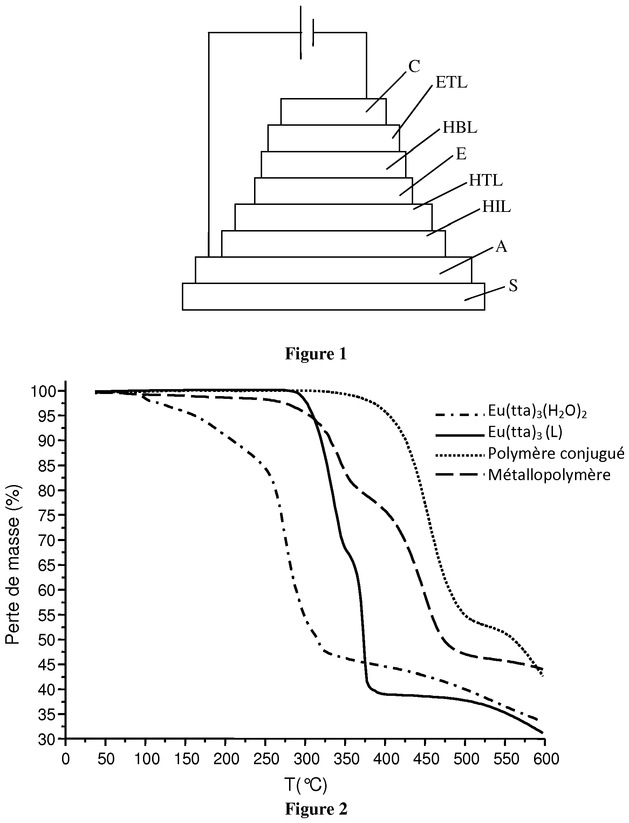

La structure optimisée d'une diode électroluminescente organique comporte plusieurs couches de matériaux actifs. Elle présente une succession de matériaux empilés entre deux électrodes, tel que représenté sur la figure 1. Sur un substrat S, une anode transparente est déposée, généralement de l'ITO, d'une épaisseur de 100 nm. Une fine couche (10 nm) d'un matériau favorisant l'injection des trous (HIL pour hole injecting layer) est ensuite déposée avant la couche transportrice de trous (HTL pour hole transporting layer). La couche émettrice d'une épaisseur d'environ 50 nm est ensuite déposée, puis 10 nm d'une couche bloqueuse de trous (HBL pour hole-blocking layer), 10 nm d'une couche transportrice d'électrons (ETL pour electron transporting layer). Enfin, la cathode C d'une épaisseur d'environ 100 nm est déposée.

Dans ce type de structure, les matériaux utilisés sont des molécules organiques pouvant être sublimées. Elles sont déposées par un procédé d'évaporation thermique sous ultra-vide. Ce procédé n'est pas seulement coûteux en énergie mais n'est pas viable pour l'élaboration de dispositifs sur grands substrats.

Les diodes électroluminescentes à base de polymères solubles (PLED de l'anglais polymer light emitting diode) sont également développées pour la facilité de mise en oeuvre par voie liquide de ces polymères, permettant l'utilisation de techniques de dépôt peu coûteuses et l'emploi de substrats souples et/ou de grande taille. Les PLEDs comprennent une couche émettrice composée d'un unique polymère semi-conducteur et luminescent, d'un mélange de polymères, ou d'un polymère dopé par un composé moléculaire luminescent.

Le polymère semi-conducteur électroluminescent peut être un métallopolymère. Au sens de la présente invention, on entend par le terme « métallopolymère » un polymère organique relié à un complexe métallique dont le centre est un ion de type lanthanide. En particulier, la chaîne polymérique peut être conjuguée et l'ion métallique peut être rattaché au squelette polymérique de façon non conjuguée. Les métallopolymères comportant une chaîne conjuguée peuvent bénéficier d'avantages supplémentaires comme des propriétés d'émission et de conduction intrinsèque à la conjugaison.

Pei et al. (Pei, J.; Liu, X.-L.; Yu, W.-L.; Lai, Y.-H.; Niu, Y.-H.; Cao, Y., Macromolecules, 2002, 35, 7274-7280) décrivent un métallopolymère comportant une chaîne conjuguée constituée d'une alternance de motifs fluorène et de motifs phényles avec un groupement (2,2'-bipyrid-5-yl)-nonyloxy pendant sur chacun des motifs phényles. Le groupement 2,2'-bipyridyl sert de site de coordination pour un complexe d'europium. La diode électroluminescente polymère fabriquée avec ce polymère émet dans le rouge.

La voie de synthèse utilisée dans le document cité ci-dessus ne permet pas de savoir quelle quantité d'ion lanthanide a été greffée au sein du polymère. La variation du taux d'ion lanthanide est effectuée uniquement en changeant les quantités de matière utilisées en début de synthèse et ne dépend pas du taux de groupement permettant la coordination. Le taux d'ion lanthanide est donc inséré de manière totalement aléatoire. De plus, les auteurs décrivent un transfert d'énergie de la chaîne polymère vers l'ion lanthanide, ce qui annihile complètement l'émission de lumière du polymère et a pour conséquence la seule émission rouge de l'europium.

Il existe donc toujours un besoin de nouveaux métallopolymères qui offrent la possibilité de moduler les propriétés de conduction (charges positives et négatives) et d'émission (ratio entre l'émission de la chaîne conjuguée du polymère et celle du ou des centres métalliques) et qui peuvent être mis en forme aisément, notamment par le biais de techniques de dépôt en solution.

Il est ainsi du mérite de la Demanderesse d'avoir mis au point de nouveaux métallopolymères hybrides multifonctionnels comprenant une chaîne conjuguée formée de motifs fluorène et carbazole qui jouent le double rôle d'émetteur bleu et de transporteur de trous. Dans ces polymères, tout ou partie des motifs carbazole sont substitués au niveau de l'atome d'azote par des groupements transporteurs d'électrons qui servent en même temps de site de coordination d'ions lanthanides.

Un objet de la présente invention concerne donc un métallopolymère constitué d'unités de répétition de formule I 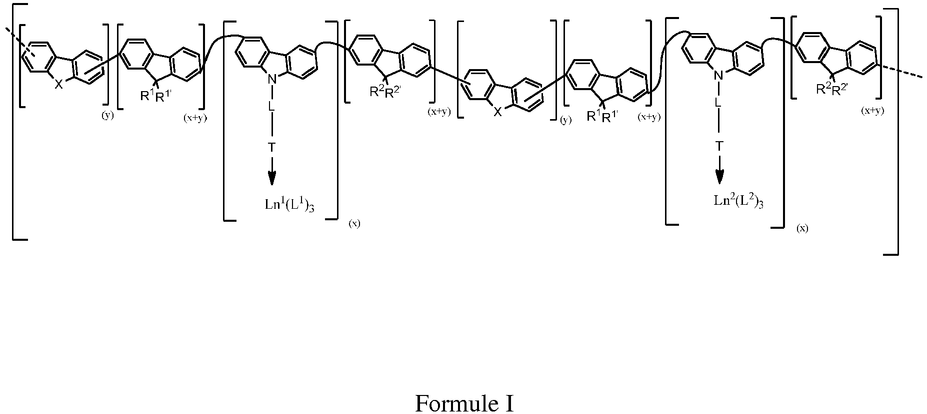 dans laquelle
R¹ et R^{1'} sont indépendamment l'un de l'autre un groupement alkyle en C₂-C₁₀, de préférence en C₆-C₈ ;
R² et R^{2'} sont indépendamment l'un de l'autre un groupement alkyle en C₂-C₁₀, de préférence en C₆-C₈ ;
X est CR³R^{3'} ou NR⁴ ;
R³ et R^{3'} sont indépendamment l'un de l'autre un groupement alkyle en C₂-C₁₀, de préférence en C₆-C₈ ;
R⁴ est un groupement alkyle en C₂-C₁₀, de préférence en C₆-C₈ ;
L est un groupement alkylène en C₄-C₁₀, de préférence en C₄-C₆ ;
T est une base de Lewis neutre bidendate comportant deux atomes d'azote coordinants ;
→ représente une coordination du groupement T via les deux atomes d'azote de T à Ln¹ et Ln² respectivement ;
Ln¹ et Ln² sont indépendamment l'un de l'autre choisis parmi les cations de lanthanides ;
L¹ et L² sont indépendamment l'un de l'autre choisis parmi les ligands mono-anioniques β-dicétonates, picolinates ou dipicolinates;
x est compris entre 0,01 et 0,50 ;
y est compris entre 0 et 0,49, la somme de x+y étant égale à 0,50.

Les métallopolymères de l'invention présentent tout d'abord l'avantage de comporter des groupements transporteurs des deux types de charges. La chaîne conjuguée composée de groupements fluorène et carbazole peut servir d'émetteur bleu et transporte préférentiellement les trous. Les liaisons entre les différents motifs de la chaîne conjuguée du métallopolymère selon l'invention se font en position 3 et 6 sur les motifs carbazoles et en position 2 et 7 sur les motifs fluorènes.

L'utilisation de lanthanides est avantageuse puisqu'elle permet l'obtention de propriétés d'émission particulièrement intéressantes. Du fait des raies d'émission très fines des lanthanides, la couleur émise par ceux-ci est extrêmement pure. De plus, la couleur d'émission est spécifique à chaque ion de lanthanide et elle n'est pas influencée par l'environnement chimique contrairement aux autres éléments d. Ainsi, quel que soit le groupement organique présent autour de l'ion lanthanide, la couleur d'émission de cet ion sera toujours la même. D'un point de vue économique, l'utilisation des ions lanthanides est également très avantageuse. Les sels de lanthanides utilisés pour l'obtention des métallopolymères sont beaucoup moins coûteux que ceux de leurs homologues avec les autres métaux de transition de type d tels que Ta, W, Ir, Pt, Au, Hg. A titre d'exemple, à pureté et quantité égales, le chlorure d'europium coûte dix fois mon cher que le chlorure d'iridium..

D'une manière générale, tous les cations trivalents des lanthanides peuvent être utilisés. Ln¹ et Ln² peuvent donc être choisi indépendamment l'un de l'autre parmi les cations trivalents de lanthane (La³⁺), cérium (Ce³⁺), praséodyme (Pr³⁺), néodyme (Nd³⁺), samarium (Sm³⁺), europium (Eu³⁺), gadolinium (Gd³⁺), terbium (Tb³⁺), dysprosium (Dy³⁺), holmium (Ho³⁺), erbium (Er³⁺), thulium (Tm³⁺), ytterbium (Yb³⁺) et lutécium (Lu³⁺), notamment parmi Eu³⁺, Tb³⁺, Tm³⁺, Dy³⁺, Sm³⁺, Nd³⁺, Yb³⁺ et Er³⁺.

Pour la conception de diodes électroluminescentes, les ions lanthanides émettant dans le rouge, dans le vert, dans le bleu, dans le jaune et dans l'orange sont particulièrement intéressants. Dans cette optique, Ln¹ et Ln² sont de préférence choisis parmi Eu³⁺, Tb³⁺, Tm³⁺, Dy³⁺, Sm³⁺. De préférence encore, Ln¹ et Ln² sont choisis parmi Eu³⁺ et Tb³⁺, c'est-à-dire l'un de Ln¹ et Ln² est Eu³⁺ et l'autre est Tb³⁺ ou Ln¹ et Ln² sont tous les deux Eu³⁺ ou tous les deux Tb³⁺. Lorsque de la lumière blanche est recherchée, l'un de Ln¹ et Ln² est de préférence Eu³⁺ et l'autre est Tb³⁺.

Les ligands β-dicétonates L¹ et L² sont avantageusement choisi indépendamment l'un de l'autre dans le groupe constitué par le benzoylactétonate (bzac), le benzoyltrifluoroacétonate (btfac), le dibenzoylméthanate (dbm), l'hexafluoroacétylacétonate (hfac), le 2-thénoyltrifluoroacétonate (tta), le 2,2,6,6,-tetraméthyl-3,5-heptanedione (thd), le 6,6,7,7,8,8,8-heptafluoro-2,2,diméthyl-3,5-octanedionate et l'acétylacétonate (acac). Les ligands picolinates et dipicolinates sont fonctionalisés de manière à être respectivement bi- et tri-dentates pour les ions lanthanides. L'homme du métier saura choisir les ligands appropriés en fonction de l'ion lanthanide. Ainsi, on utilisera par exemple de préférence le dbm et/ou le tta dans le cas de l'Eu³⁺ et l'acac ou un picolinate dans le cas du Tb³⁺.

Dans un mode de réalisation, Ln¹ et Ln² sont tous les deux Eu³⁺ et L¹ et L² sont tous les deux tta.

Dans un autre mode de réalisation, Ln¹ est Eu³⁺ et Ln² est Tb³⁺ et L¹ et L² sont tous les deux tta.

R¹ et R^{1'} peuvent être différents ou identiques, de préférence ils sont identiques. On choisira de façon avantageuse des groupements alkyles linéaires en C₆-C₈ : *n*-hexyl, *n-*heptyl, *n*-octyl, de préférence *n*-octyl.

R² et R^{2'} peuvent être différents ou identiques, de préférence ils sont identiques. On choisira de manière avantageuse des groupements alkyles linéaires en C₆-C₈ : *n*-hexyl, *n-*heptyl, *n*-octyl, de préférence *n*-octyl.

Avantageusement, R¹, R^{1'}, R² et R^{2'} sont identiques, de préférence ils sont tous n-octyl.

R³ et R^{3'} peuvent être différents ou identiques, de préférence ils sont identiques. Avantageusement, on choisira des groupements alkyles linéaires en C₆-C₈ : *n*-hexyl, *n-*heptyl, *n*-octyl, de préférence *n*-hexyl.

R⁴ est avantageusement un groupement alkyle linéaire en C₆-C₈ : *n*-hexyl, *n*-heptyl, *n*-octyl, de préférence *n*-hexyl.

L est avantageusement un groupement alkylène linéraire en C₄-C₆ : *n*-butylène, *n-*pentylène, *n*-héxylène, de préférence *n*-butylène.

T est relié à la chaîne conjuguée par L, transporte préférentiellement les électrons et sert de site de coordination pour les ions lanthanides. T est avantageusement une base de Lewis neutre bidendate comportant deux atomes d'azote coordinants choisie dans le groupe constitué de la benzimidazole-pyridine, du thiabendazole, de la 1,10-phénanthroline et de la 2,2'-bipyridine, chacun de ces groupements pouvant être substitué ou non. De préférence, T est choisi dans le groupe constitué du benzimidazole, du thiabendazole, chacun de ces groupements pouvant être substitué ou non. Plus préférentiellement encore T est de la benzimidazole-pyridine, substituée ou non.

Plus particulièrement, T peut être choisi parmi les groupements suivants : 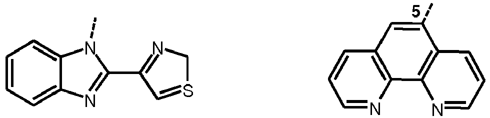 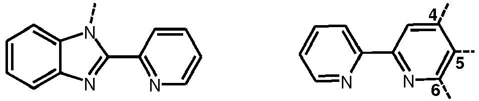 où ---- représente le point d'attache à L et où chacun de ces groupements peut être substitué ou non. Dans le cas, de la 2,2'-bipyridine le point d'attache peut donc être au niveau de l'atome de carbone en positions 4, 5 ou 6.

La constitution même des métallopolymères de l'invention permet de moduler leurs propriétés d'émission et de conduction de charges.

Il est ainsi possible d'influer sur les propriétés de transport d'électrons et sur le taux d'ions lanthanides en faisant varier le taux de groupements T.

La voie de synthèse des métallopolymères de la présente invention présente donc l'avantage de permettre de moduler de façon contrôlée les propriétés de conduction des charges positives en faisant varier la nature de la chaîne conjuguée (rapport carbazole/fluorène), le transport des électrons en influant sur le taux de groupements T insérés au sein du composé et la couleur d'émission en jouant sur le ratio entre l'émission bleue de la chaîne polymère et celle du ou des lanthanide(s).

De manière générale x est 0,01 à 0,50 et y 0 à 0,49, la somme de x et y étant toujours égale à 0,50. De préférence, x est 0,01 à 0,35 et y 0,15 à 0,49.

Des métallopolymères de formule I préférés sont des métallopolymères constitués d'unité de répétition de formule I' 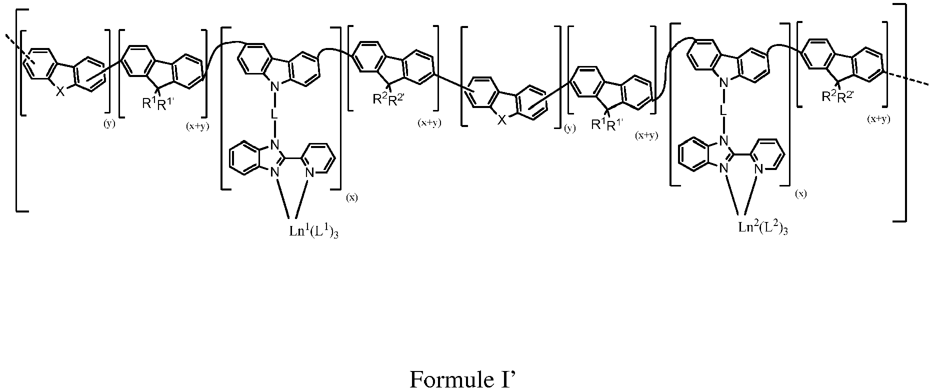 dans laquelle R¹, R^{1'}, R², R^{2'}, X, L, Ln¹, Ln², L¹, L², x et y sont tels que définis ci-dessus par rapport à la Formule I.

Comme indiqué précédemment, il est possible d'influer sur les propriétés d'émission et de transport de trous en faisant varier le rapport carbazole/fluorène dans la chaîne conjuguée. La conjugaison entre plusieurs motifs fluorène permet d'augmenter l'émission bleue, la présence croissante d'entités carbazole augmente le transport des trous.

Aussi, dans une première variante, le métallopolymère de l'invention est un métallopolymère consistant en des unités de répétition selon la formule IA : 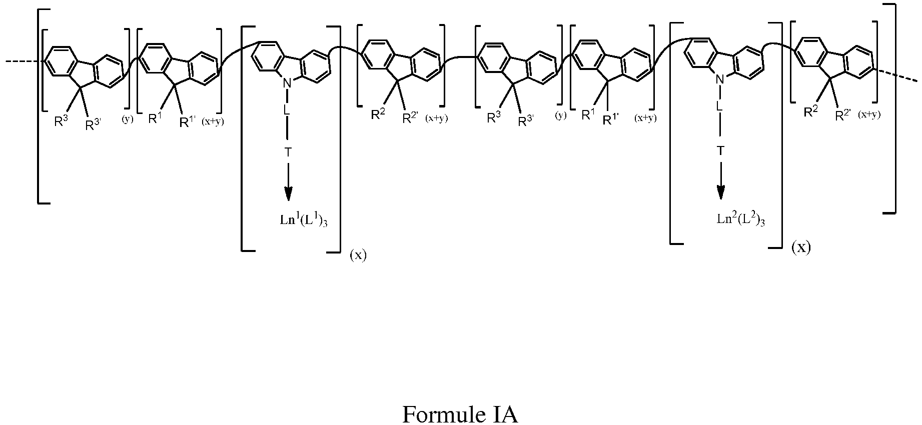 dans laquelle R¹, R^{1'}, R², R^{2'}, R³, R^{3'}, L, T, Ln¹, Ln², L¹, L², x et y sont tels que définis ci-dessus par rapport à la Formule I.

Des métallopolymères de formule IA préférés sont des métallopolymères constitués d'unité de répétition de formule l'A 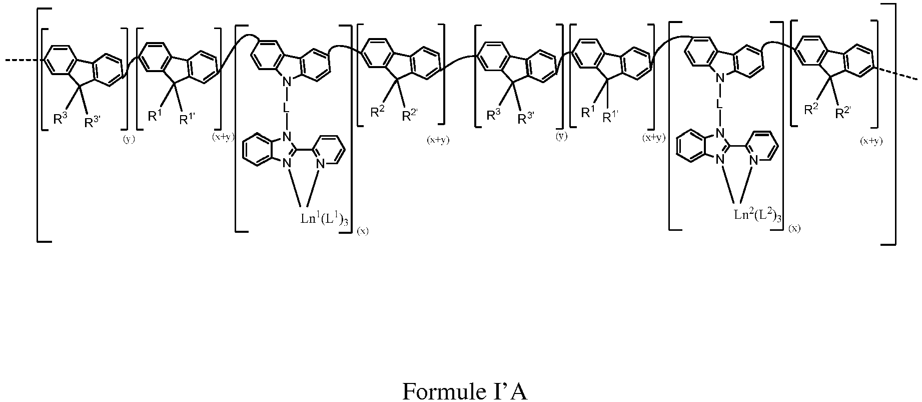 dans laquelle R¹, R^{1'}, R², R^{2'}, R³, R^{3'}, L, Ln¹, Ln², L¹, L², x et y sont tels que définis ci-dessus par rapport à la Formule I.

Dans une seconde variante, le métallopolymère de l'invention est un métallopolymère consistant en des unités de répétition selon la formule IB : 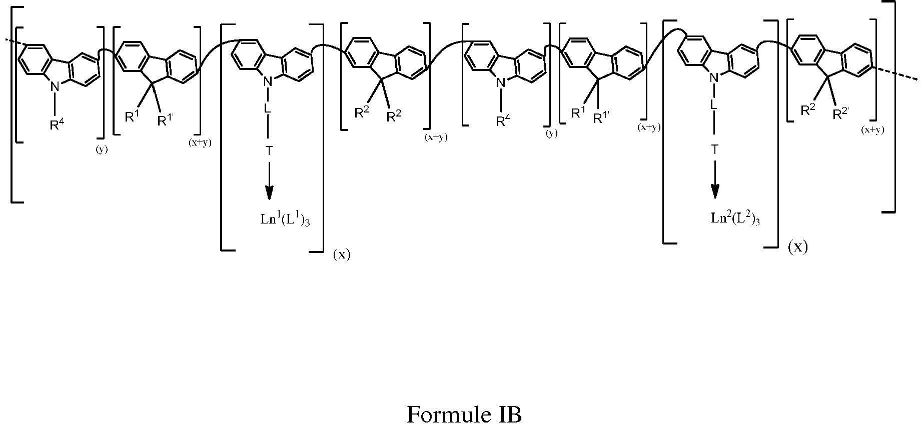 dans laquelle R¹, R^{1'}, R², R^{2'}, R⁴, L, T, Ln¹, Ln², L¹, L², x et y sont tels que définis ci-dessus par rapport à la Formule I.

Des métallopolymères de formule IB préférés sont des métallopolymères constitués d'unité de répétition de formule I'B 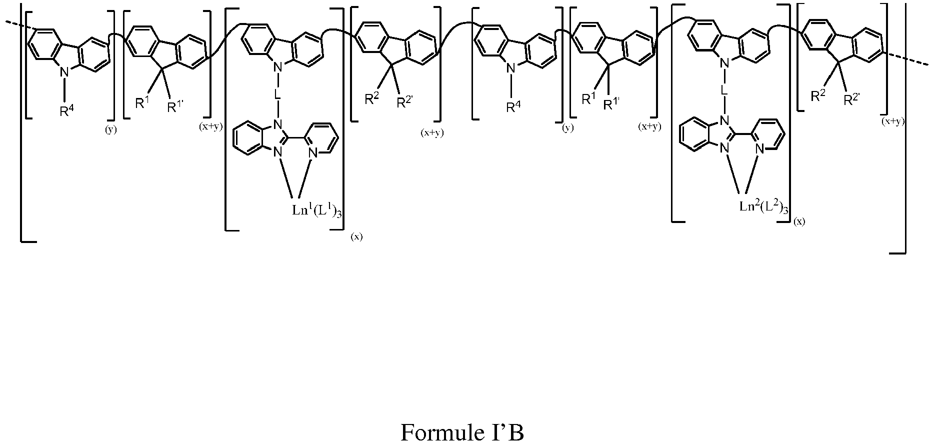 dans laquelle R¹, R^{1'}, R², R^{2'}, R⁴, L, Ln¹, Ln², L¹, L², x et y sont tels que définis ci-dessus par rapport à la Formule I.

Les métallopolymères de l'invention sont obtenus en faisant réagir un polymère conjugué de formule II 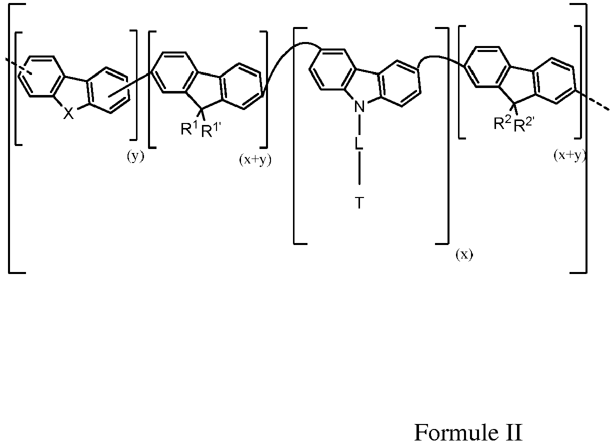 dans laquelle R¹, R^{1'}, R², R^{2'}, R³, R^{3'}, R⁴, L, T, x et y sont tels que définis ci-dessus par rapport à la Formule I,
avec un ou deux complexes de lanthanides de formule [Ln(L)₃(H₂O)₂], dans lequel Ln est choisi parmi les cations de lanthanides et L est choisi parmi les ligands mono-anioniques β-dicétonates, picolinates ou dipicolinates, dans un solvant organique.

Les métallopolymères de la formule IA tels que définis ci-dessus sont ainsi obtenus en faisant réagir un polymère conjugué de formule IIA 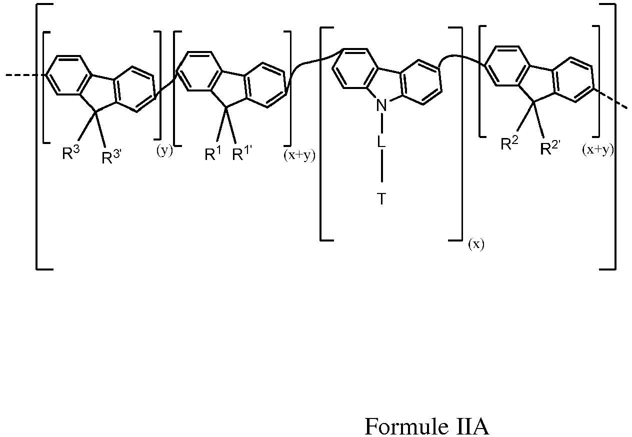 dans laquelle R¹, R^{1'}, R², R^{2'}, R³, R^{3'}, L, T, x et y sont tels que définis ci-dessus par rapport aux Formules I et IA respectivement,
avec un ou deux complexes de lanthanides de formule [Ln[(L)₃(H₂O)₂], dans lequel Ln est choisi parmi les cations de lanthanides et L est choisi parmi les ligands mono-anionqiues β-dicétonates, picolinates ou dipicolinates, dans un solvant organique.

De la même façon, on obtient les métallopolymères de la formule IB tels que définis ci-dessus en faisant réagir un polymère conjugué de formule IIB 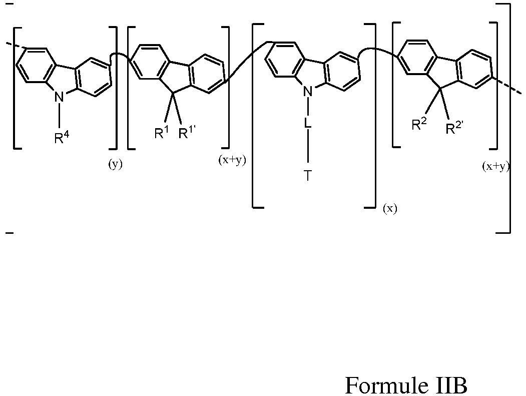 dans laquelle R¹, R^{1'}, R², R^{2'}, R⁴, L, T, x et y sont tels que définis ci-dessus par rapport aux Formules I et IA respectivement,
avec un ou deux complexes de lanthanides de formule [Ln(L)₃(H₂O)₂], dans lequel Ln est choisi parmi les cations de lanthanides et L est choisi parmi les ligands mono-anioniques β-dicétonates, picolinates ou dipicolinates, dans un solvant organique.

Les métallopolymères préférés de formules I', l'A et I'B sont obtenus de manière analogue à partir de polymères conjugués préférés de formules II', II'A et II'B 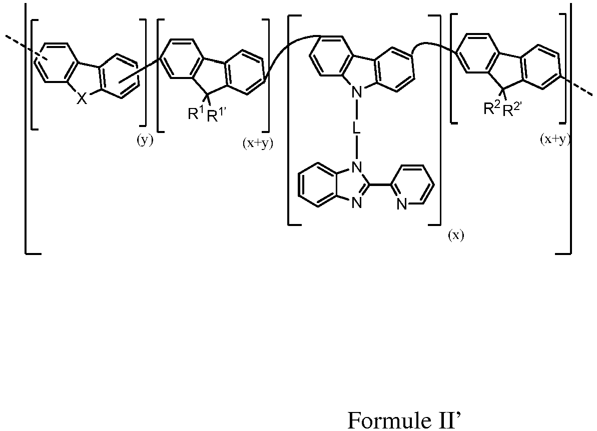 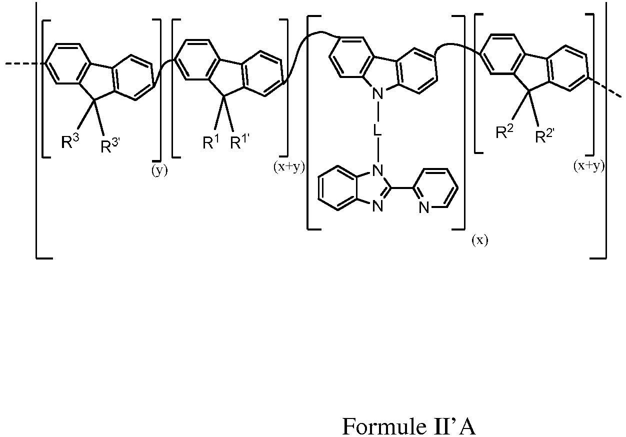 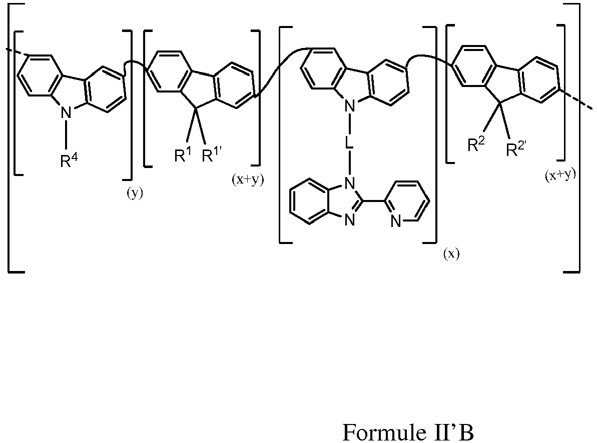 dans lesquelles X, R¹, R^{1'}, R², R^{2'}, R³, R^{3'}, R⁴, L, x et y sont tels que définis ci-dessus par rapport à la Formule I.

L'invention concerne par conséquent aussi les polymères conjugués de formules II, IIA, IIB, II', II'A et II'B tels que définis ci-dessus.

Les polymères conjugués de l'invention peuvent être synthétisés par couplage de Suzuki entre un di-ester boronique 4 comportant un motif fluorène, un composé di-bromé 5 comportant un motif fluorène ou un motif carbazole et un composé 3,6-dibromo-9-(4-(2-pyridin-2-yl-benzoimidazol-1-yl)-C₄-C₆ alkyl)-9H-carbazole6.

Un grand avantage des polymères conjugués de l'invention réside dans le fait qu'ils peuvent être synthétisés à partir de monomères facilement accessibles, notamment à partir de monomères commerciaux dans le cas de motifs fluorène dans lesquels R¹, R^{1'}, R², R^{2'} sont *n*-hexyl ou *n*-octyl.

Un autre avantage réside dans la possibilité de varier la constitution de la chaîne conjuguée en contrôlant l'alternance des groupements la constituant. Ainsi, les propriétés de conduction de charges et d'émission peuvent être ajustées en fonction du taux de chacun des monomères.

Grâce à leurs propriétés de transport de charges positives et négatives, et d'émission, les métallopolymères de l'invention sont particulièrement intéressants pour l'élaboration de diodes électroluminescentes polymères. Un autre objet de l'invention est donc l'utilisation des métallopolymères de l'invention pour la fabrication de diodes électroluminescentes polymères. Ces diodes comprennent une couche d'un métallopolymère selon l'invention qui est généralement disposée entre une anode et une cathode. Dans ces diodes électroluminescentes, le métallopolymère selon l'invention joue à la fois le rôle de transporteur d'électron, de transporteur de trous et de matériau émetteur.

Un avantage des métallopolymères de l'invention réside dans le fait qu'ils peuvent être déposés par des techniques de dépôt en solution ce qui est moins coûteux que les techniques de dépôt sous vide et permet l'utilisation de supports de plus grande taille et par conséquent la fabrication de dispositifs de plus grande taille.

### DESCRIPTION DES FIGURES

La Figure 1 est une représentation schématique d'une diode électroluminescente organique multicouche de l'état de la technique.
La figure 2 présente un comparatif des courbes ATG des deux complexes métalliques : [Eu(tta)₃(H₂O)₂], [Eu(tta)₃(L)], avec celle du métallopolymère de l'Exemple 5 et celle du polymère conjugué correspondant.
La figure 3 présente un comparatif des courbes ATG des deux complexes métalliques : [Eu(tta)₃(H₂O)₂], [Eu(tta)₃(L)], avec celle du métallopolymère de l'Exemple 6 et celle du polymère conjugué correspondant.
La Figure 4 présente le spectre d'émission en solution du métallopolymère de l'Exemple 5.
La Figure 5 présente le spectre d'émission en solution du métallopolymère de l'Exemple 6.
La Figure 6 présente le spectre d'émission sur film mince du métallopolymère de l'Exemple 6.
La figure 7 est une représentation schématique d'une diode électroluminescente de l'exemple 9.
La figure 8 présente le spectre d'électroluminescence d'une diode électroluminescente polymère selon l'invention.

### EXEMPLES

Les analyses de chromatographie par exclusion stérique (SEC) ont été réalisées sur un appareil Malvern Discotek GPC/SEC équipé d'un détecteur UV et d'un détecteur par variation d'indice de réfraction.

Les analyses thermogravimétriques ont été réalisées sur un appareil Netzsch STA 409 PC Luxx® analyzer sous flux d'azote. La température de décomposition a été évaluée pour une perte de masse de 5%.

Les spectres de photoluminescence ont été enregistrés sur un spectromètre Jobin Yvon Fluoromax4. Les mesures de rendement de photoluminescence en solution ont été réalisées sur un spectromètre Jobin Yvon Fluorolog3 équipé d'une sphère d'intégration.

### Synthèse du 3,6-dibromo-9-(4-(2-pyridine-2-yl-benzoimidazole-1-yl)-butyle)-9H-carbazole :

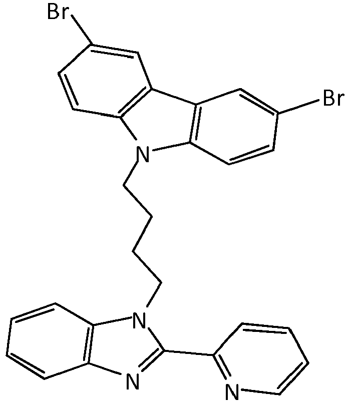

Première étape de synthèse : Le 3,6-dibromo-9-(4'-bromobutyle)carbazole (**1**) :

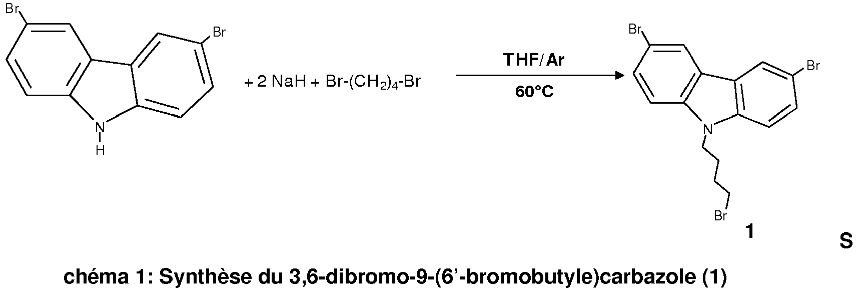

En boîte à gants, 2g (6,2 mmol) de 3,6-dibromocarbazole sont dissous dans 20 mL de THF anhydre. 295 mg (12,3 mmol) d'hydrure de sodium sont ensuite ajoutés par faibles quantités à la solution. L'ajout de ce composé provoque un fort dégagement gazeux lié à la formation de dihydrogène, entrainé par la déprotonation du 3,6-dibromocarbazole. 2,2 mL (18,5 mmol) de 1,4-dibromobutane sont ensuite ajoutés au milieu réactionnel à l'aide d'une seringue. L'injection se fait sous flux d'argon. La réaction est effectuée sous atmosphère inerte. Le mélange réactionnel est agité pendant 12 h et porté à reflux. L'excès de NaH est ensuite éliminé par filtration. Une extraction par le dichlorométhane est réalisée sur le filtrat. La phase organique est séchée à l'aide de sulfate de magnésium et le solvant est évaporé sous vide après filtration. Enfin, le produit final (1) est obtenu par recristallisation dans l'éthanol. Le composé synthétisé est un solide beige obtenu avec un rendement de 49%.

Ce composé a été caractérisé par RMN ¹H. Le spectre du 3,6-dibromo-9-(4'-bromobutyl)carbazole est donné en Annexe 1 : 8,10 ppm (d, 2H, *⁴J*=1,8 Hz, H1 et H4), 7,54 ppm (dd, 2H, *³J*=8,7 Hz *⁴J*=1,8 Hz, H2 et H5), 7,23 ppm (d, 2H, *³J*=8,7 Hz, H3 et H6), 4,25 ppm (t, 2H, *³J*=6,3 Hz, H7 et H8), 3,36 ppm (t, 2H, *³J*=6,3 Hz, H13 et H14), 1,93 ppm (m, 4H, H9, H10, H11 et H12).

### Deuxième étape de synthèse : le 3,6-dibromo-9-(4-(2-pyridine-2-yl-benzoimidazole-1-yl)-butyle)-9H-carbazole (2) :

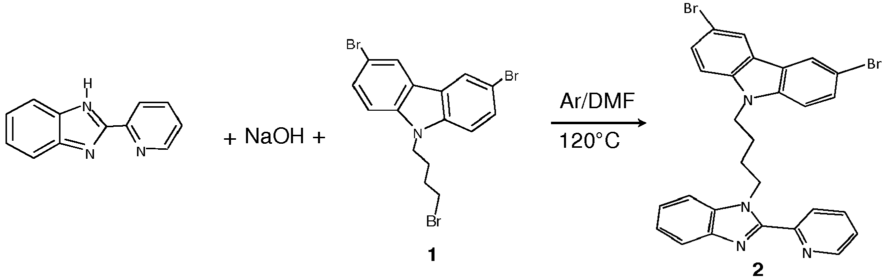

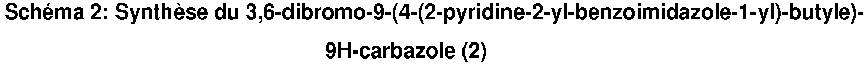

La synthèse de ce composé est effectuée sous atmosphère inerte. 369 mg (1,89 mmol) de 2-(2-pyridyl)benzimidazole sont préalablement dissous dans 20 mL de DMF anhydre. 113 mg (2,84 mmol) d'hydroxyde de sodium puis 870 mg (1,89 mmol) de 3,6-dibromo-9-(6'-bromobutyl)carbazole sont ajoutés au milieu réactionnel qui est porté à reflux et agité pendant 12 heures. Une extraction par le dichlorométhane est ensuite réalisée. La phase organique est séchée sur du sulfate de magnésium. Une partie du solvant de la phase organique est évaporée sous vide après filtration et le composé recristallise à froid dans une solution très concentrée ; il est obtenu avec un rendement de 74 %.

Le rendement global comprenant les deux étapes de synthèse présentées précédemment est de 47%.

Le spectre de RMN ¹H du composé 2 a été enregistré dans le chloroforme deutéré. Il met en évidence la présence de deux groupes de signaux : ceux des atomes d'hydrogènes de la chaine alkyle et les signaux des atomes d'hydrogène aromatiques du carbazole et du groupement pyridyl-benzimidazole : 8,54 ppm (d, 1H, ⁴*J* = 4,8 Hz, Py-H), 8,43 ppm (d, 1H, ³*J* =7,9 Hz, Py-H) 8,10 ppm (d, 2H, *⁴J* =1,8 Hz, H1 et H4), 7,87 ppm (td, 2H, Py-H) 7,54 ppm (dd, 2H, *³J* =8,7 Hz *⁴J* =1,8 Hz, H2 et H5), 7,39 ppm (m, 4H, Ar-H) 7,23 ppm (d, 2H, *³J* =8,7 Hz, H3 et H6), 4,80 ppm (t, 2H, *³J* =6,3 Hz, H13 et H14), 4,25 ppm (t, 2H, *³J* =6,3 Hz, H7 et H8), 1,93 ppm (m, 4H, H9, H10, H11 et H12).

### Synthèse du 3,6-dibromo-9-hexyle-9H-carbazole (3)

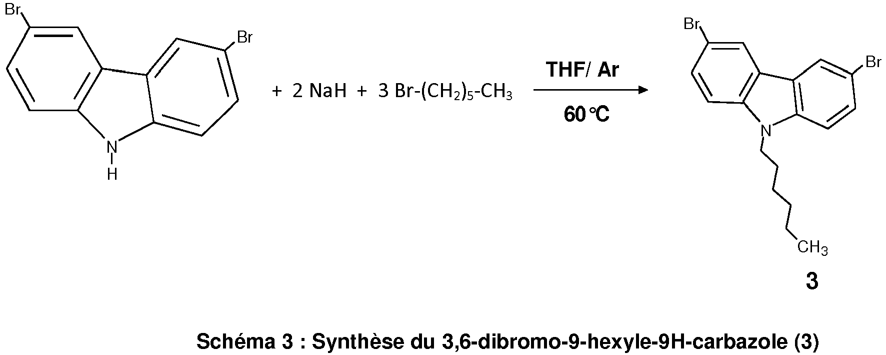

En boîte à gants, 1,5g (4,6 mmol) de 3,6-dibromocarbazole sont dissous dans 15 mL de THF anhydre. 221 mg (9,2 mmol) d'hydrure de sodium sont ensuite ajoutés par faibles quantités à la solution afin d'éviter un dégagement gazeux trop violent lié à la formation de dihydrogène, causé par la déprotonation du 3,6-dibromocarbazole. 1,7 mL (13,8 mmol) de 1-bromohexane sont ensuite injectés au milieu réactionnel sous flux d'argon. La réaction est effectuée sous atmosphère inerte. Le mélange réactionnel est agité pendant 12 h et porté à reflux à une température de 65°C. L'excès de NaH est ensuite éliminé par filtration. Une extraction par le dichlorométhane est réalisée sur le filtrat. La phase organique est séchée sur du sulfate de magnésium et le solvant est évaporé sous vide. Le composé obtenu se présente sous la forme de cristaux beige foncé. Le rendement est de 60%.

Le spectre de RMN ¹H du 3,6-dibromo-9-(6'-bromobutyle)carbazole a été enregistré dans le chloroforme deutéré : 8,10 ppm (d, 2H, ⁴*J* =1,8 Hz, H1 et H4), 7,54 ppm (dd, 2H, ³*J* =8,7 Hz ⁴*J* =1,8 Hz, H2 et H5), 7,23 ppm (d, 2H, ³*J* =8,7 Hz, H3 et H6), 4,25 ppm (t, 2H, ³*J* =6,3 Hz, H7 et H8), 2,1 ppm (t, 2H, ³*J* =6,3 Hz, H15 et H16), 1,93 ppm (m, 6H, H9, H10, H11,H12, H13, H14), 0,8 ppm (m, 3H, H17, H18, H19).

### Synthèse du tris(2-thénoyltrifluoroacétonato) bis aquo europium(III) : [Eu(tta)₃(H2O)₂] (4)

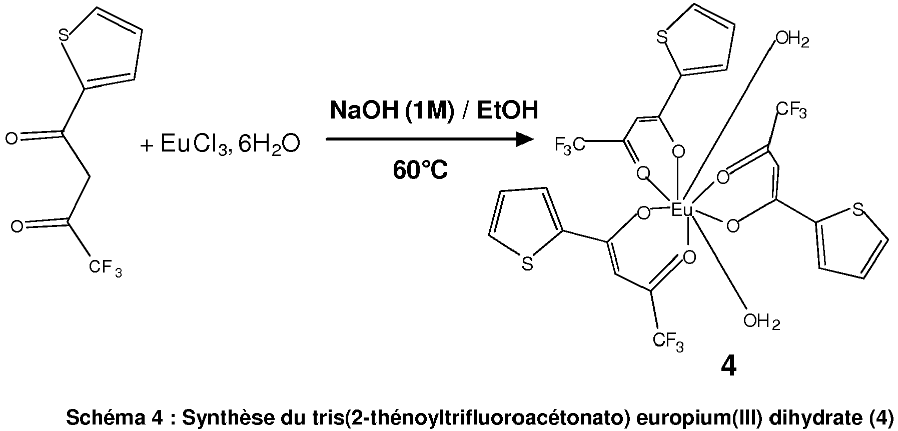

1g de Htta (4,5 mmol) est dissous dans 20 mL d'éthanol absolu. 4,5 mL d'une solution aqueuse d'hydroxyde de sodium de concentration C = 1 mol.L⁻¹ sont ajoutés au milieu réactionnel afin de permettre la déprotonation de la β-dicétone. Le mélange est ensuite agité pendant une heure. 550 mg de chlorure d'europium hexahydraté (1,5 mmol) sont dissous dans 50 mL d'eau distillée. Cette solution est ajoutée lentement à la solution de β-dicétonate. Le mélange réactionnel est enfin agité pendant 12 heures à 60 °C. Un précipité de couleur jaune pâle se forme. Il est récupéré par filtration puis séché sous vide. Le rendement est de 71%.

### Synyhèse du tris(2-thénoyltrifluoroacétonato) {3,6-Dibromo-9-(4-(2pyridine-2-yl-benzoimidazole-1-yl)-butyle)-9H-carbazole} europium(III): [Eu(tta)3L](5) (avec L pour {3,6-Dibromo-9-(4-(2-pyridine-2-yl-benzoimidazole-1-yl)-butyle)-9H-carbazole})

Le tris(2-thénoyltrifluoroacétonato){3,6-dibromo-9-(4-(2-pyridine-2-yl-benzoimidazole-1-yl)-butyle)-9H-carbazole} europium(III) est obtenu par réaction entre le composé **4** et le composé **2** dans le THF sous atmosphère inerte (Schéma 5).

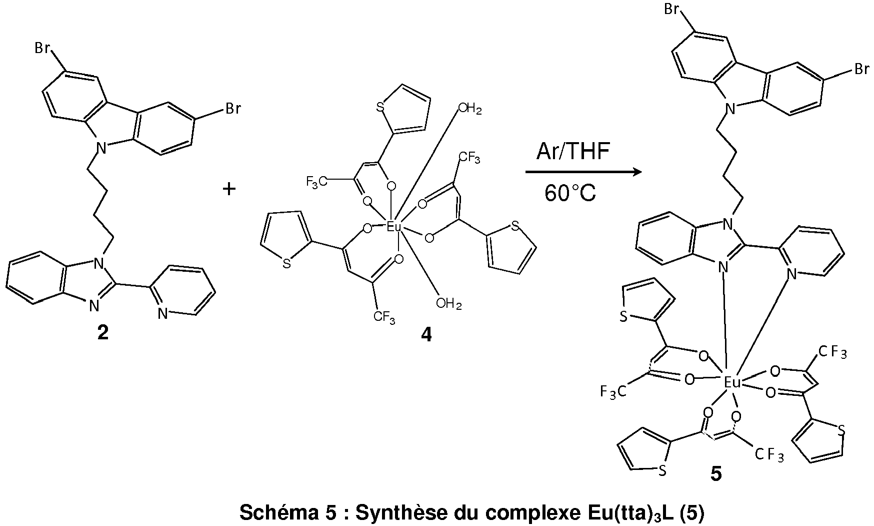

En boîte à gants, une solution de 1 g (1,16 mmol) du complexe Eu(tta)₃(H₂O)₂ dans 10 mL de THF anhydre est ajoutée lentement à une solution de 0,67g de 3,6-dibromo-9-(4-(2-pyridine-2-yl-benzoimidazole-1-yl)-butyle)-9H-carbazole (1,16 mmol) dans 5 mL de THF anhydre. Le milieu réactionnel est ensuite agité pendant 12 heures à 60 °C. Des ajouts successifs de quelques millilitres de pentane entrainent la formation d'un précipité qui est récupéré par filtration puis séché sous vide. Le composé obtenu est une poudre de couleur beige clair et le rendement de la réaction est de 51%.

Le complexe a été caractérisé par analyse élémentaire.
AE : Calculé pour: C₅₂H₃₄Br₂EuF₉N₄O₆S₃: C, 44.94%; H, 2.47% ; N, 4.03%
Trouvé: C, 44.95%; H, 2.34%; N, 4.03%

### Exemple 1 : Synthèse d'un polymère conjugué de formule IIA avec x = 0,35 et y =0,15

Le catalyseur de palladium(0) Pd(OAc)₂ a été formé in situ à partir de 2,2 mg (17,8 µmol) d'acétate de palladium(II) et de 8,9 mg (53,9 µmol) de tri-p-tolylphosphine dans 15 mL de toluène. 438 mg (0,87 mmol) d'ester bipinacolique de l'acide 2,7-diboronique de 9,9-di-n-hexylfluorène, 350 mg (0,61 mmol) de 3,6-dibromo-9-(4-(2-pyridine-2-ylbenzoimidazole-1-yl)-butyle)-9H-carbazole, 79 mg (0,16 mmol) de 9,9-dihexyl-2,7-dibromofluorène, ainsi que 4,5 mL d'une solution aqueuse d'hydroxyde de tetraéthylammonium à 20% ont été ajoutés à la solution de toluène contenant le catalyseur. Le milieu réactionnel a été porté à reflux à 120 °C pendant 72 heures. Afin de terminer la chaîne polymérique, 54 µL (51 µmol) de bromobenzène et 67 mg (55 µmol) d'ester d'acide phénylboronique ont successivement été ajoutés à 5 h d'intervalle. Le mélange réactionnel obtenu a été introduit goutte à goutte dans 200 mL de méthanol. Le précipité gris a été récupéré par filtration puis dissout dans du chloroforme (50 mL). La solution a de nouveau été ajoutée goutte à goutte dans 200 mL de méthanol. Le solide a été séparé de la solution de méthanol par filtration puis lavé avec de l'acétone dans un Soxhlet pendant 48 h.

Le polymère conjugué obtenu a été caractérisé par chromatographie par exclusion stérique (SEC) : *Mₙ* = 5979, *M_{w}* = 8371, Indice de polydispersité I = 1,4.

### Exemple 2 : Synthèse de polymères conjugués de formule IIA avec différents taux de carbazole fonctionalisé

Les polymères de formule IIA suivants ont été synthétisés selon le mode opératoire de l'exemple 1 en utilisant des taux différents des monomères utilisés à l'Exemple 1 : x=0,01 et y =0,49 ; x=0,05 et y =0,45 ; x=0,1 et y =0,4 ; x=0,2 et y =0,3 ; x=0,35 et y=0,15.

Les polymères conjugués obtenus ont été caractérisés par chromatographie par exclusion stérique (SEC). Les résultats sont présentés au tableau 1 ci-après.

**Tableau 1**

| **x** | **y** | **Poids moléculaire en nombre (*Mn*)** | **Poids moléculaire en masse (*Mw*)** | **Indice de polydispersité (*I*)** |
|---|---|---|---|---|
| 0,01 | 0,49 | 17560 | 27043 | 1,5 |
| 0,05 | 0,45 | 17727 | 38747 | 2,2 |
| 0,10 | 0,40 | 22593 | 60835 | 2,7 |
| 0,20 | 0,30 | 8997 | 10210 | 1,1 |

### Exemple 3 : Synthèse d'un polymère conjugué de formule IIB avec x = 0,2 et y =0,3

Le catalyseur de palladium(0) est formé in situ à partir de 2,0 mg (15 µmol) d'acétate de palladium(II) et de 8,2 mg (49,6 µmol) de *tri-p-*tolylphosphine dans 10 mL de toluène. 91 mg (0,158 mmol) de 3,6-dibromo-9-(4-(2-pyridine-2-yl-benzoimidazole-1-yl)-butyle)-9H-carbazole et 98 mg (0,239 mmol) de 3,6-dibromo-9-hexyl-9H-carbazole sont ensuite ajoutés à la solution de toluène. En boîte à gants, 16 mg d'aliquat 336 sont dissous dans 5 mL de toluène et injectés sous flux d'argon au milieu réactionnel. 255,5 mg (0,397 mmol) d'ester bipinacolique de l'acide 2,7-diboronique de 9,9-di-*n*-hexylfluorène et 1,5 mL d'une solution aqueuse de carbonate de potassium de concentration C = 2 mol.L⁻¹ sont ensuite ajoutés au milieu réactionnel qui est agité et porté à 120 °C pendant 72 heures. Enfin 24 µL (23 µmol) de bromobenzène et 29 mg (24 µmol) d'ester d'acide phénylboronique sont successivement ajoutés à 5 h d'intervalle. Le mélange réactionnel est ajouté goutte à goutte dans 200 mL de méthanol. Le solide est récupéré par filtration puis dissout dans du chloroforme (50 mL). La solution est de nouveau ajoutée goutte à goutte dans 200 mL de méthanol. Le polymère conjugué solide est récupéré par filtration, séché, puis lavé par l'acétone dans un soxhlet pendant 48 h.

Le polymère conjugué obtenu a été caractérisé par chromatographie par exclusion stérique (SEC) : *Mₙ* = 6553, *M_{w}* = 10121, Indice de polydispersité I = 1,5.

### Exemple 4 : Synthèse d'un polymère conjugué de formule IIB avec différents taux de carbazole fonctionalisé

Les polymères de formule IIB suivants ont été synthétisés selon le mode opératoire de l'exemple 3 en utilisant des taux différents des monomères utilisés à l'Exemple 3 : x = 0,01 et y = 0,49 ; x = 0,05 et y = 0,45 ; x = 0,10 et y = 0,40 ; x = 0,35 et y = 0,15 ; x = 0,50 et y = 0.

Les polymères conjugués obtenus ont été caractérisés par chromatographie par exclusion stérique (SEC). Les résultats sont présentés au tableau 2 ci-après.

**Tableau 2**

| **Taux (x ; y)** | **Poids moléculaire en nombre (*Mn*)** | **Poids moléculaire en masse (*Mw*)** | **Indice de polydispersité (*I*)** |
|---|---|---|---|
| **0,01 ; 0,49** | 8998 | 13242 | 1,5 |
| **0,05 ; 0,45** | 5831 | 6845 | 1,2 |
| **0,10 ; 0,40** | 6098 | 8591 | 1,4 |
| **0,20 ; 0,30** | 6553 | 10121 | 1,5 |
| **0,35 ; 0,15** | 7837 | 11602 | 1,5 |
| **0,50 ; 0,00** | 5547 | 8229 | 1,5 |

### Exemple 5 : Synthèse d'un métallopolymère de formule IA avec x = 0,35 et y =0,65

En boîte à gants, 100 mg du polymère conjugué de l'Exemple 1 ont été dissous dans 10 mL de chloroforme anhydre. Une solution contenant 100 mg (117 mmol) de [Eu(tta)₃(H₂O)₂] dans 10 mL de chloroforme anhydre a été ajoutée goutte à goutte à celle contenant le polymère organique. Le mélange a ensuite été placé sous agitation pendant 12 h à 60 °C. Le complexe [Eu(tta)₃(H₂O)₂] est en large excès par rapport à la quantité de sites à coordiner au sein de la chaîne polymère afin de forcer la coordination du complexe métallique sur tous les sites. Le solvant a été évaporé sous vide. Le solide ainsi récupéré a été lavé par de petites portions de méthanol froid afin d'éliminer l'excès de [Eu(tta)₃(H₂O)₂]. Il a été récupéré par filtration puis séché.

Le métallopolymère obtenu a été caractérisé par chromatographie par exclusion stérique (SEC) : *Mₙ* = 6811, *M_{w}* = 8696, Indice de polydispersité I = 1,3.

La masse molaire moyenne en nombre (*Mₙ*) mesurée est supérieure à celle enregistrée pour le polymère conjugué de départ. Cela signifie que le volume hydrodynamique (espace occupé par les macromolécules en solution) des métallopolymères est plus élevé que celui des polymères conjugués ayant servi à leur synthèse. Cela peut s'expliquer par une gêne stérique induit par la présence des groupements Eu(tta)₃ au sein des chaînes du polymère. Ceci constitue donc une bonne indication que le complexe métallique a bien été coordiné au sein des chaînes du polymère.

### Exemple 6 : Synthèse d'un métallopolymère de formule IB avec x = 0,2 et y =0,3

En boîte à gants, 100 mg du polymère conjugué de l'Exemple 3 ont été dissous dans 10 mL de chloroforme anhydre. Une solution contenant 60 mg (51 mmol) de [Eu(tta)₃(H₂O)₂] dans 5 mL de chloroforme anhydre a été ajoutée goutte à goutte à celle contenant le polymère organique. Le mélange a ensuite été placé sous agitation pendant 12 h à 60 °C. Le complexe [Eu(tta)₃(H₂O)₂] est en large excès par rapport à la quantité de sites à coordiner au sein de la chaîne polymère afin de forcer la coordination du complexe métallique sur tous les sites. Le solvant a été évaporé sous vide. Le solide ainsi récupéré a été lavé par de petites portions de méthanol froid afin d'éliminer l'excès de [Eu(tta)₃(H₂O)₂]. Il a été récupéré par filtration puis séché.

Le métallopolymère obtenu a été caractérisé par chromatographie par exclusion stérique (SEC) : *Mₙ* = 7039, *M_{w}* = 10874, Indice de polydispersité I = 1,5.

Comme pour le métallopolymère de l'Exemple 5 les différences de valeur entre les Mn et les Mw du métallopolymère et du polymère conjugué ayant servi à sa synthèse confirme que le complexe métallique a bien été coordiné au sein des chaînes du polymère.

### Exemple 7 : Analyse thermogravimétrique et DSC des polymères conjugués et des métallopolymères

Des analyses thermogravimétriques ont été effectuées sur les polymères conjugués des Exemples 1 à 4, les métallopolymères correspondants (Exemples 5 et 6) ainsi que sur les complexes tris(2-thenoyltrifluoroacétonato) {3,6-dibromo-9-(4-(2-pyridine-2-yl-benzoimidazole-1-yl)-butyle)-9H-carbazole} europium(III) : Eu(tta)₃(L) avec L pour 3,6-dibromo-9-(4-(2-pyridine-2-yl-benzoimidazole-1-yl)-butyle)-9H-carbazole) et tris(2-thénoyltrifluoroacétonato) bis aquo europium(III) : [(Eu(tta)₃(H₂O)₂].

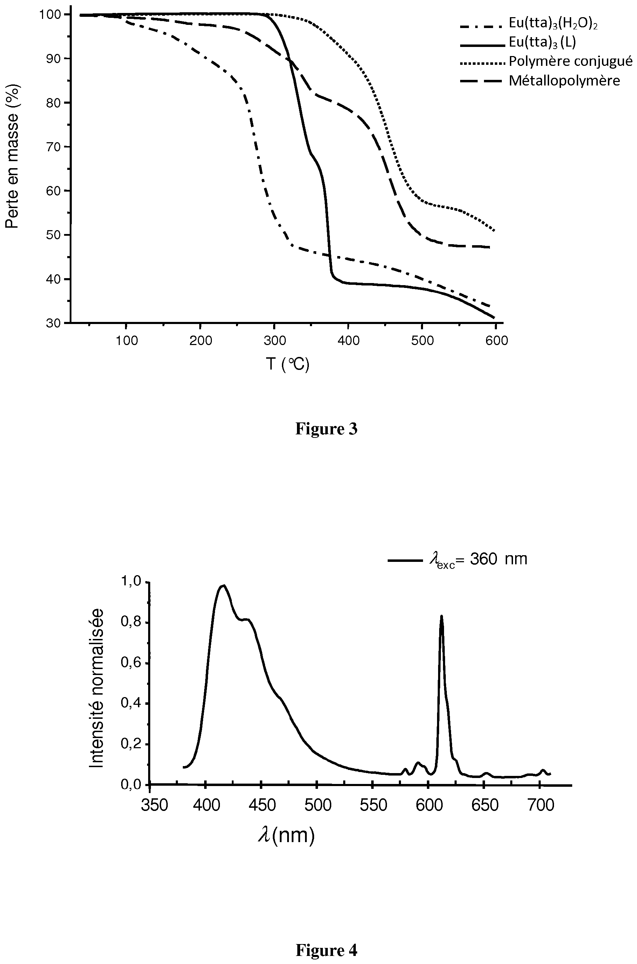

Les figures 2 et 3 présentent un comparatif des courbes ATG des deux complexes métalliques : [Eu(tta)₃(H₂O)₂], [Eu(tta)₃(L)], avec celles de chacun des deux métallopolymères des Exemples 5 et 6 et celles des polymères conjugués ayant servi à l'obtention de ces derniers.

La figure 2 présente ce comparatif pour le métallopolymère de l'Exemple 5 : la perte de masse enregistrée aux alentours de 100 °C sur la courbe du complexe [Eu(tta)₃(H₂O)₂] correspond à la perte de molécules d'eau situées dans la deuxième sphère de coordination du lanthanide. La deuxième perte de masse située vers 180 °C peut elle être attribuée à la perte des molécules d'eau directement liées au métal. La perte de masse enregistrée à 320 °C qui est beaucoup plus conséquente correspond à la perte de deux ligands tta. Pour le complexe [Eu(tta)₃(L)], la perte de masse enregistrée vers 350 °C peut également être attribuée à la perte de deux ligands tta. Sur la courbe du métallopolymère, il est possible de noter deux pertes de masse significatives : une première aux alentours de 350 °C qui est analogue à celle observée pour le complexe [Eu(tta)₃(L)] et une deuxième à plus haute température qui intervient dans le polymère conjugué seul et qui est liée au début de la rupture des chaînes alkyles des motifs fluorènes. Ce comparatif permet donc de mettre en évidence que le métallopolymère subit deux pertes de masses relatives à chacun des groupements qui le constituent, le complexe métallique et le polymère organique. Les courbes ATG confirment donc elles aussi que le complexe métallique a bien été coordiné au sein des chaînes polymères.

La figure 3 présente ce comparatif pour le métallopolymère de l'Exemple 6 : La courbe ATG du métallopolymère de l'Exemple 6 montre également deux pertes de masses bien distinctes, une première intervenant vers 350 °C, correspondant à la perte de deux ligands -dicétonates et une deuxième plus haute en température qui correspond comme dans le polymère conjugué à la dégradation des chaînes alkyles greffées sur les motifs aromatiques.

Le tableau 3 donne les valeurs de températures de décomposition (*T_{d}*) évaluées pour chacun des composés présentés aux figures 2 et 3. Elles ont été mesurées pour une perte en masse de 5%.

**Tableau 3**

| **Caractéristique du composé** | ***T_{d}* (°C) ± 1°C** |
|---|---|
| [Eu(tta)₃(H₂O)₂] | 162 |
| [Eu(tta)₃(L)] | 309 |
| Métallopolymère (Exemple 5) | 305 |
| Polymère conjugué associé (x=0,35) | 405 |
| Métallopolymère (Exemple 7) | 275 |
| Polymère conjugué associé (x=0,2 ; y=0,3) | 374 |

Les valeurs présentées dans le tableau 1 montrent que malgré la présence d'un groupement métallique, les métallopolymères présentent des températures de décomposition élevées, paramètre important pour leur utilisation dans des diodes électroluminescentes.

### Exemple 8 : Etude photophysique des métallopolymères

Les spectres d'émission des métallopolymères des exemples 5 et 6 en solution ont été enregistrés à partir de solution réalisées dans le dichlorométhane avec une concentration massique de 100 µg/mL.

Le spectre d'émission du métallopolymère de l'exemple 6 a été enregistré sur film mince a été obtenu à partir d'une solution réalisée dans du chlorobenzène et de concentration massique de 12 mg/mL déposée par spin-coating. La couche émettrice de la diode électroluminescente réalisée est déposée dans des conditions analogues.

La Figure 4 présente le spectre d'émission en solution du métallopolymère de l'Exemple 5. Il comporte deux bandes bien distinctes, une dans le bleu, similaire à celle observée avec le polymère organique seul, et une dans le rouge, caractéristique de l'émission de l'europium(III).

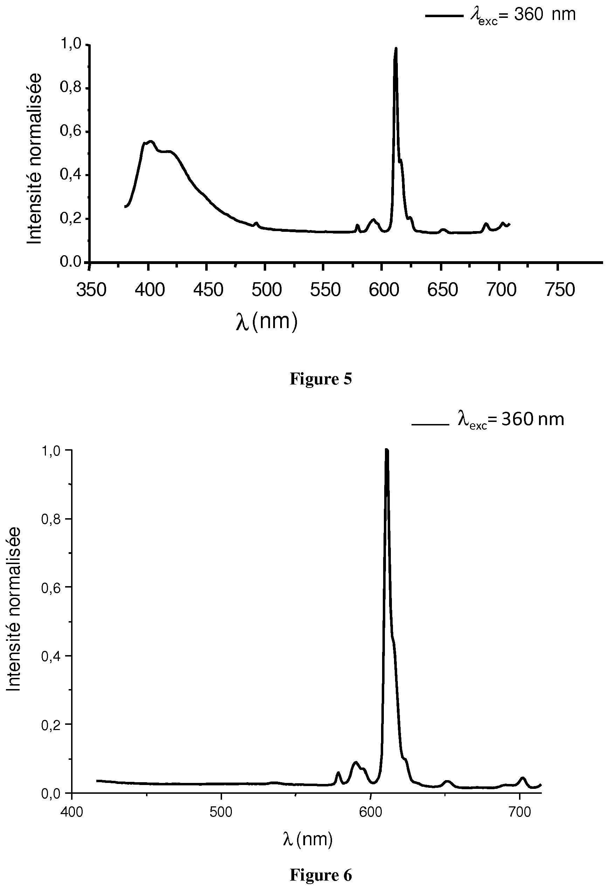

La Figure 5 présente le spectre d'émission en solution du métallopolymère de l'Exemple 6. Il présente deux bandes différentes, l'une dans le bleu, attribuable au polymère conjugué et l'autre dans le rouge caractéristique de l'europium(III), la bande enregistrée dans le rouge étant la plus intense.

La Figure 6 présente le spectre d'émission sur film mince du métallopolymère de l'Exemple 6.

### Exemple 9 : Diode électroluminescente polymère (PLED)

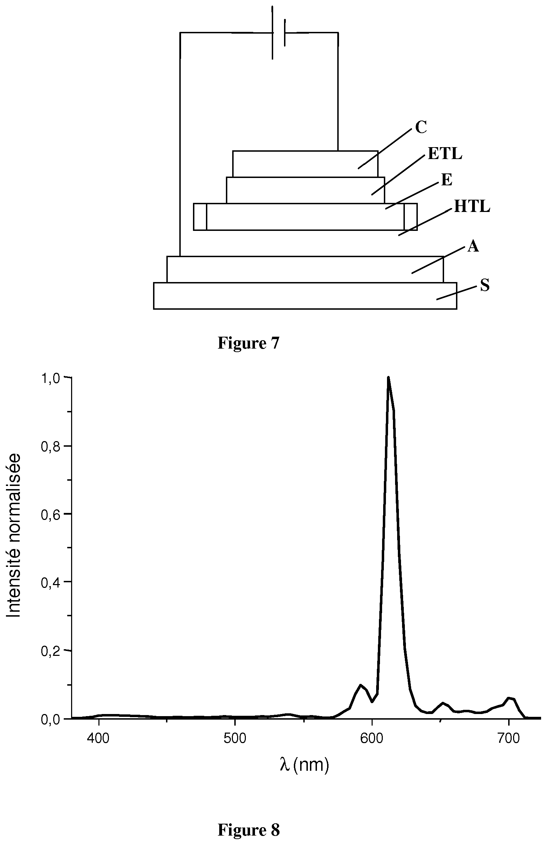

Une diode électroluminescente polymère a été réalisée avec le métallopolymère de l'Exemple 6. Cette diode, représentée de façon schématique sur la Figure 7, comporte successivement sur un substrat (S) en verre une anode (A) en oxyde d'indium-étain (ITO) de 100 nm, une couche transportrice de trous (HTL) de 40 nm en PEDOT-PSS, une couche de 100 nm du métallopolymère de l'exemple 6 (E), une couche transportrice d'électrons (ETL) en TPBI de 50 nm et une cathode (C) en LiF/Al de 100 nm.

Le dispositif avec cette structure présente une couleur d'émission rouge. Le spectre d'électroluminescence est présenté sur la Figure 8.

## Revendications

1. Métallopolymère constitué d'unités de répétition de formule I 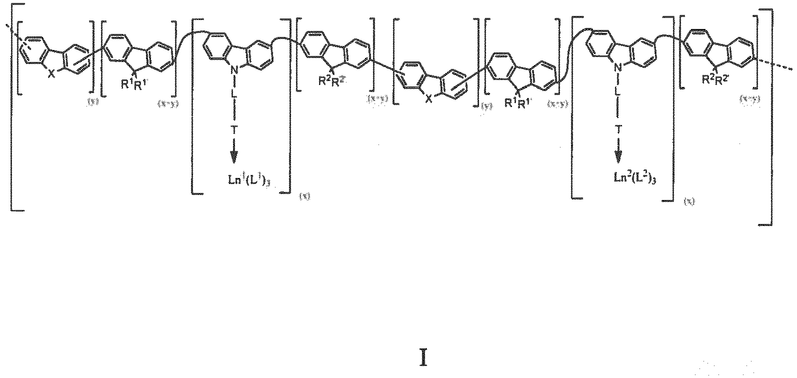 dans laquelle
R¹ et R^{1'} sont indépendamment l'un de l'autre un groupement alkyle en C₂-C₁₀ ;
R² et R^{2'} sont indépendamment l'un de l'autre un groupement alkyle en C₂-C₁₀ ;
X est CR³R^{3'} ou NR⁴ ;
R³ et R^{3'} sont indépendamment l'un de l'autre un groupement alkyle en C₂-C₁₀ ;
R⁴ est un groupement alkyle en C₂-C₁₀ ;
L est un groupement alkylène en C₄-C₁₀ ;
T est une base de Lewis neutre bidendate comportant deux atomes d'azote coordinants ;
→ représente une coordination du groupement T via les deux atomes d'azote de T à Ln¹ et Ln² respectivement ;
Ln¹ et Ln² sont indépendamment l'un de l'autre choisis parmi les cations de lanthanides ;
L¹ et L² sont indépendamment l'un de l'autre choisis parmi les ligands mono-anioniques β-dicétonate, picolinates ou dipicolinates ;
x est compris entre 0,01 et 0,50 ;
y est compris entre 0 et 0,49, la somme de x+y étant égale à 0,50.

2. Métallopolymère selon la revendication 1, constitué d'unités de répétition de formule IA 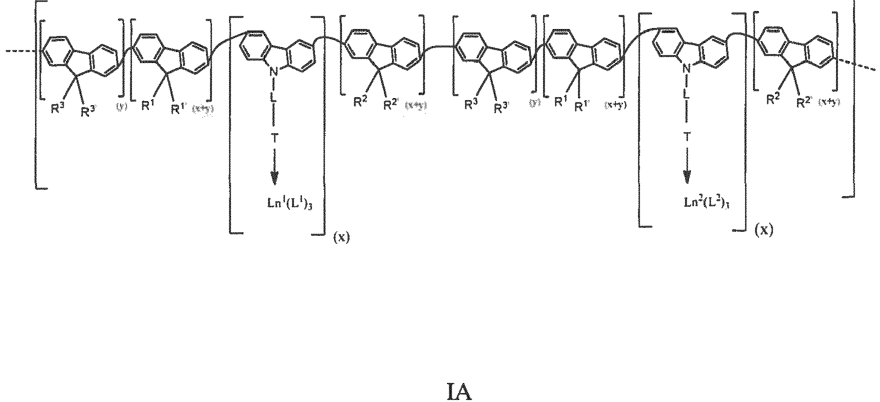 dans laquelle R¹, R^{1'}, R², R^{2'}, R³, R^{3'}, L, T Ln¹, Ln², L¹, L², x et y sont tels que définis à la revendication 1.

3. Métallopolymère selon la revendication 1, constitué d'unités de répétition de formule IB 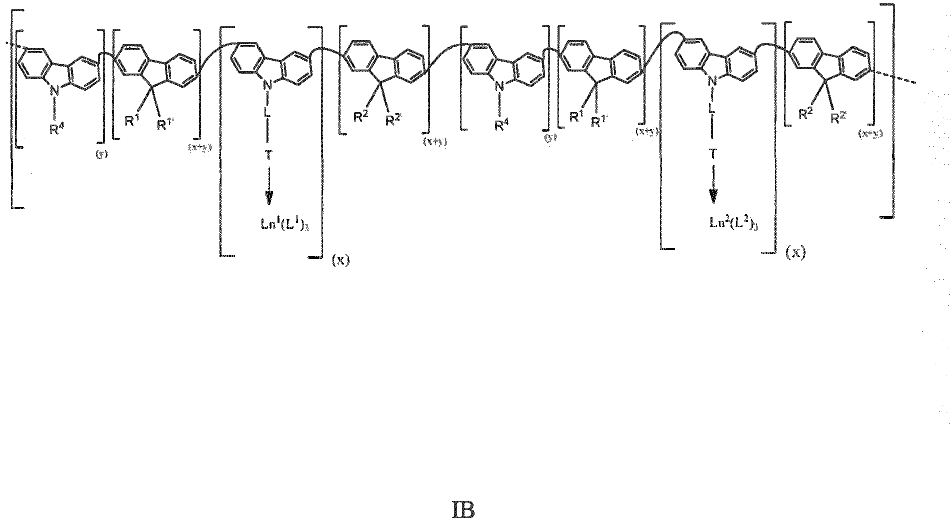 dans laquelle R¹, R^{1'}, R², R^{2'}, R⁴, L, T Ln¹, Ln², L¹, L², x, y et n sont tels que définis à la revendication 1.

4. Métallopolymère selon la revendication 1, constitué d'unités de répétition de formule I' 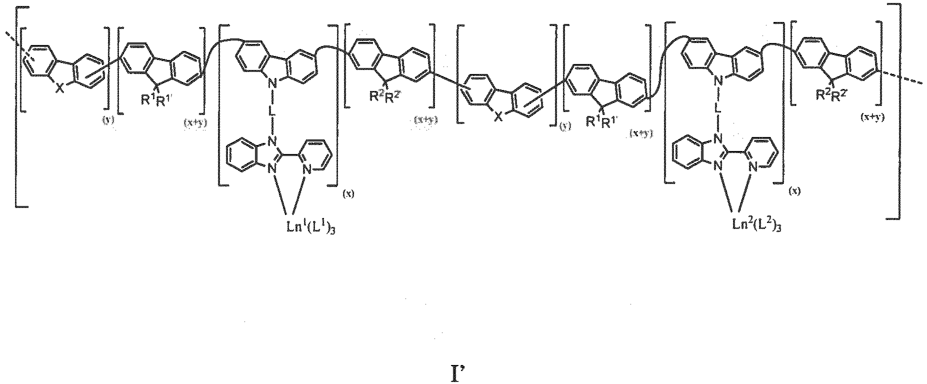 dans laquelle R¹, R^{1'}, R², R^{2'}, X, L, Ln¹, Ln², L¹, L², x et y sont tels que définis à la revendication 1.

5. Métallopolymère selon l'une quelconque des revendications 1 à 4, dans lequel R¹ et R^{1'} sont *n*-octyle.

6. Métallopolymère selon l'une quelconque des revendications 1 à 5, dans lequel R² et R^{2'} sont *n*-octyle.

7. Métallopolymère selon l'une quelconque des revendications 1 à 6, dans lequel L est *n*-butylène.

8. Métallopolymère selon l'une quelconque des revendications 1 à 7, dans lequel Ln¹ et Ln² sont tous les deux Eu³⁺ et L¹ et L² sont tous les deux tta.

9. Métallopolymère selon l'une quelconque des revendications 1 à 7, dans lequel Ln¹ est Eu³⁺ et Ln² est Tb³⁺ et L¹ et L² sont tous les deux tta.

10. Polymère conjugué constitué d'unités de répétition de formule II 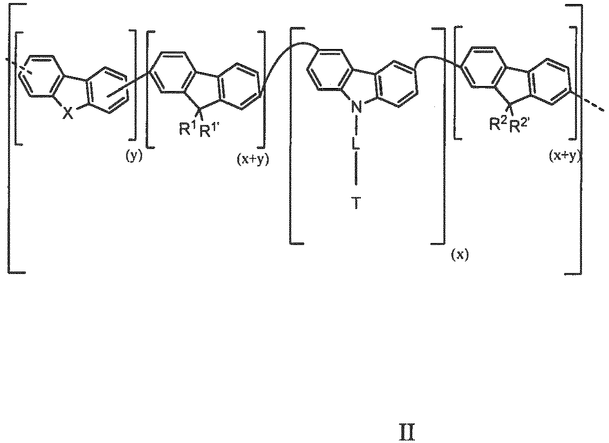 dans laquelle
R¹ et R^{1'} sont indépendamment l'un de l'autre un groupement alkyle en C₂-C₁₀ ;
R² et R^{2'} sont indépendamment l'un de l'autre un groupement alkyle en C₂-C₁₀ ;
X est CR³R^{3'} ou NR⁴ ;
R³ et R^{3'} sont indépendamment l'un de l'autre un groupement alkyle en C₂-C₁₀ ;
R⁴ est un groupement alkyle en C₄-C₁₀ ;
x est compris entre 0,01 et 0,50 ;
y est compris entre 0 et 0,49, la somme de x+y étant égale à 0,50.
L est un groupement alkylène en C₄-C₁₀ ;
T est une base de Lewis neutre bidendate comportant deux atomes d'azote coordinants.

11. Utilisation d'un métallopolymère selon l'une quelconque des revendications 1 à 9 pour la fabrication d'une diode électroluminescente.

12. Diode électroluminescente comprenant une couche d'un métallopolymère selon l'une quelconque des revendications 1 à 9.

## Patentansprüche

1. Metallpolymer, welches Wiederholungseinheiten der Formel I umfasst 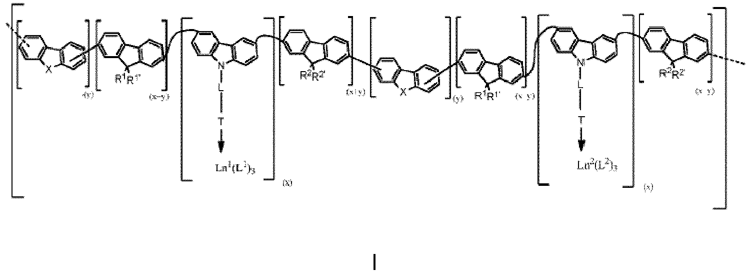 bei welcher
R¹ und R^{1'} unabhängig voneinander für eine C₂-C₁₀ Alkyl-Gruppe stehen;
R² und R^{2'} unabhängig voneinander für eine C₂-C₁₀ Alkyl-Gruppe stehen;
X für CR³R^{3'} oder NR⁴ steht;
R³ und R^{3'} unabhängig voneinander für eine C₂-C₁₀ Alkyl-Gruppe stehen;
R⁴ für eine C₂-C₁₀ Alkyl-Gruppe steht;
L für eine C₄-C₁₀ Alkylen-Gruppe steht;
T eine zweizähnige neutrale Lewis-Base ist, welche zwei koordinierende Stickstoffatome umfasst;
→für eine Koordinierung der T-Gruppe über die zwei Stickstoffatome von T an Ln¹ bzw. Ln² steht;
Ln¹ und Ln² unabhängig voneinander aus Lanthanid-Kationen gewählt sind;
L¹ und L² unabhängig voneinander aus den monoanionischen Liganden β-Dicetonat, Picolinaten oder Dipicolinaten gewählt sind;
x zwischen 0,01 und 0,50 liegt;
y zwischen 0 und 0,49 liegt, wobei die Summe aus x+y gleich 0,50 ist.

2. Metallpolymer nach Anspruch 1, welches Wiederholungseinheiten der Formel IA umfasst 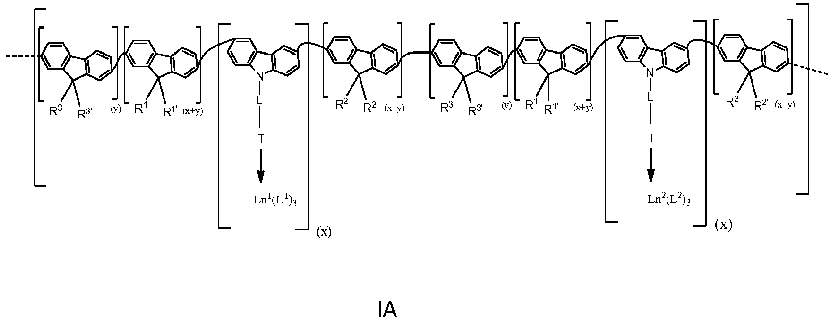 wobei R¹, R^{1'}, R², R^{2'}, R³, R^{3'}, L, T, Ln¹, Ln², L¹, L², x und y der Definition in Anspruch 1 entsprechen.

3. Metallpolymer nach Anspruch 1, welches Wiederholungseinheiten der Formel IB umfasst 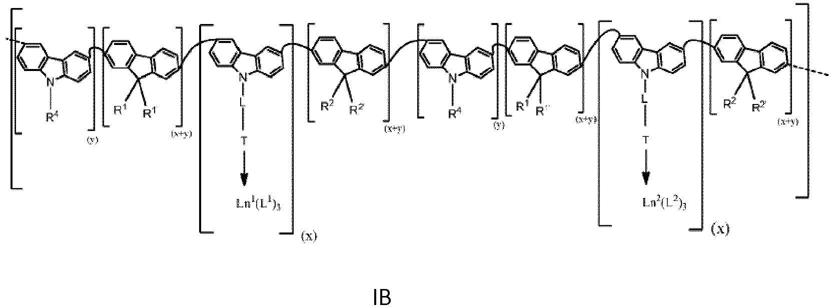 wobei R¹, R^{1'}, R², R^{2'}, R⁴, L, T, Ln¹, Ln², L¹, L², x, y und n der Definition in Anspruch 1 entsprechen.

4. Metallopolymer nach Anspruch 1, welches Wiederholungseinheiten der Formel I' umfasst 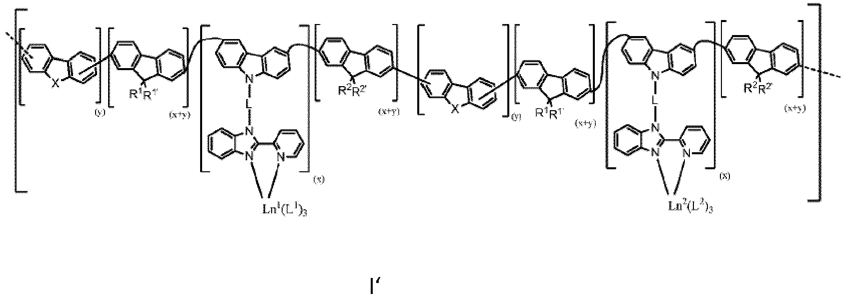 wobei R¹, R^{1'}, R², R^{2'}, X, L, Ln¹, Ln², L¹, L², x und y der Definition in Anspruch 1 entsprechen.

5. Metallpolymer nach einem der Ansprüche 1 bis 4, wobei R¹ und R^{1'} für n-Octyl stehen.

6. Metallpolymer nach einem der Ansprüche 1 bis 5, wobei R² und R^{2'} für n-Octyl stehen.

7. Metallpolymer nach einem der Ansprüche 1 bis 6, wobei L für n-Butylen steht.

8. Metallpolymer nach einem der Ansprüche 1 bis 7, wobei Ln¹ und Ln² beide Eu³⁺ sind und L¹ und L² beide tta sind.

9. Metallpolymer nach einem der Ansprüche 1 bis 7, wobei Ln¹ Eu³⁺ ist und Ln² Tb³⁺ ist und L¹ und L² beide tta sind.

10. Konjugiertes Polymer, welches Wiederholungseinheiten der Formel II umfasst 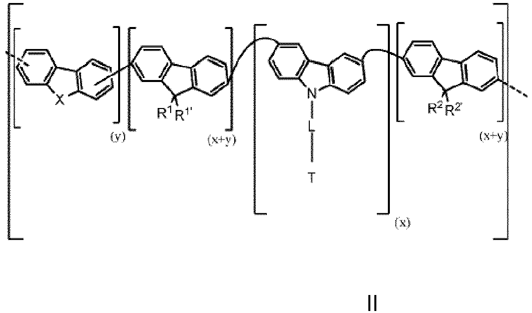 bei welcher
R¹ und R^{1'} unabhängig voneinander für eine C₂-C₁₀ Alkyl-Gruppe stehen;
R² und R^{2'} unabhängig voneinander für eine C₂-C₁₀ Alkyl-Gruppe stehen;
X für CR³R^{3'} oder NR⁴ steht;
R³ und R^{3'} unabhängig voneinander für eine C₂-C₁₀ Alkyl-Gruppe stehen;
R⁴ für eine C₄-C₁₀ Alkyl-Gruppe steht;
x zwischen 0,01 und 0,50 liegt;
y zwischen 0 und 0,49 liegt, wobei die Summe aus x+y gleich 0,50 ist.
L für eine C₄-C₁₀ Alkylen-Gruppe steht;
T eine zweizähnige neutrale Lewis-Base ist, welche zwei koordinierende Stickstoffatome umfasst.

11. Verwendung eines Metallpolymers nach einem der Ansprüche 1 bis 9 für die Herstellung einer Leuchtdiode.

12. Leuchtdiode, welche eine Metallpolymer-Schicht nach einem der Ansprüche 1 bis 9 aufweist.

## Claims

1. Metallopolymer consisting of repeating units of formula I 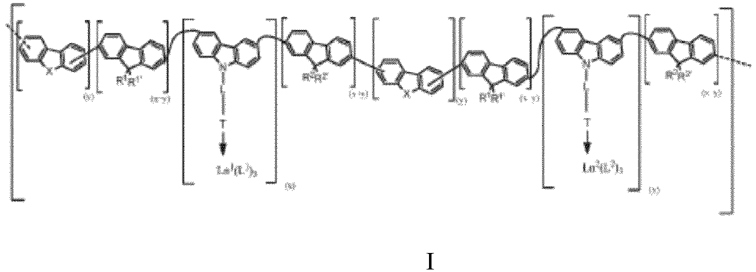 wherein
R¹ and R^{1'} are, independently from each other, a C₂-C₁₀ alkyl group;
R² and R^{2'} are, independently from each other, a C₂-C₁₀ alkyl group;
X is CR³R^{3'} or NR⁴;
R³ and R^{3'} are, independently from each other, a C₂-C₁₀ alkyl group;
R⁴ is a C₂-C₁₀ alkyl group;
L is a C₄-C₁₀ alkylene group;
T is a neutral bidentate Lewis base containing two coordinating nitrogen atoms;
→ represents a coordination of group T via the two nitrogen atoms of T to Ln¹ and Ln² respectively;
Ln¹ and Ln² are, independently from each other, chosen from the lanthanide cations;
L¹ and L² are, independently from each other, chosen from β-diketonate, picolinate or dipicolinate monoanionic ligands;
x is between 0.01 and 0.50;
y is between 0 and 0.49, the sum of x+y being equal to 0.50.

2. Metallopolymer according to claim 1, consisting of repeating units of formula IA 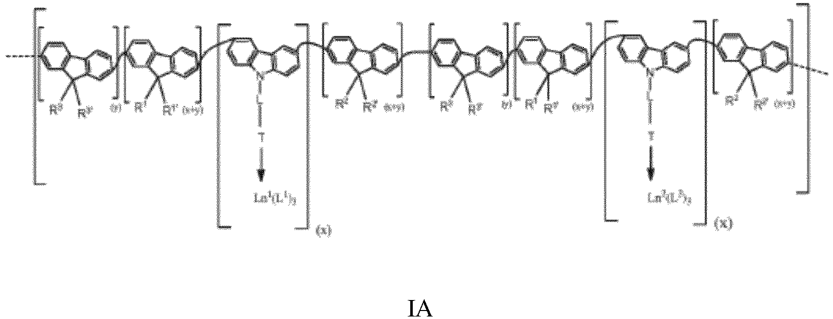 wherein R¹, R1', R², R^{2'}, R³, R^{3'}, L, T Ln¹, Ln², L¹, L², x and y are as defined in claim 1.

3. Metallopolymer according to claim 1, consisting of repeating units of formula IB 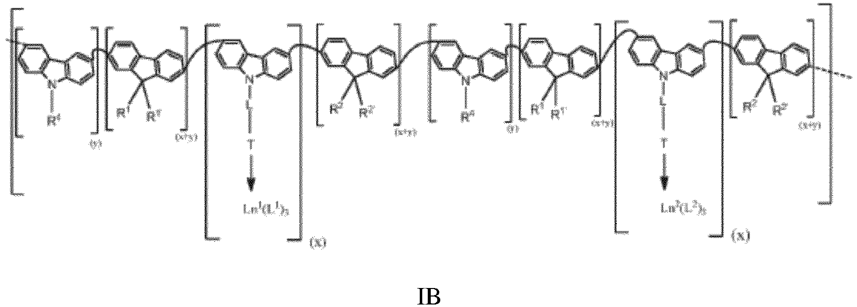 wherein R¹, R^{1'}, R², R^{2'}, R⁴, L, T Ln¹, Ln², L¹, L², x, y and n are as defined in claim 1.

4. Metallopolymer according to claim 1, consisting of repeating units of formula I' 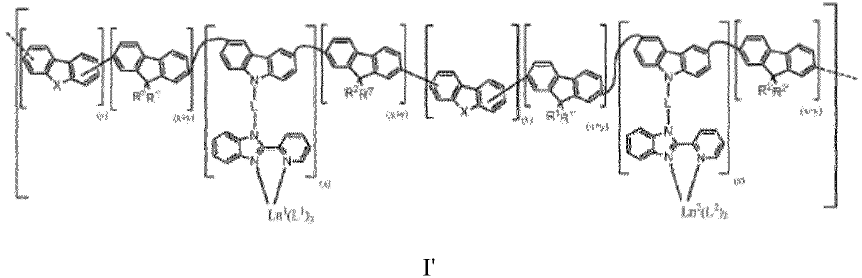 wherein R¹, R^{1'}, R², R^{2'}, X, L, Ln¹, Ln², L¹, L², x and y are as defined in claim 1.

5. Metallopolymer according to any one of claims 1 to 4, wherein R¹ and R^{1'} are *n-*octyl.

6. Metallopolymer according to any one of claims 1 to 5, wherein R² and R^{2'} are *n-*octyl.

7. Metallopolymer according to any one of claims 1 to 6, wherein L is *n*-butylene.

8. Metallopolymer according to any one of claims 1 to 7, wherein Ln¹ and Ln² are both Eu³⁺ and L¹ and L² are both tta.

9. Metallopolymer according to any one of claims 1 to 7, wherein Ln¹ is Eu³⁺ and Ln² is Tb³⁺ and L¹ and L² are both tta.

10. Conjugated polymer consisting of repeating units of formula II 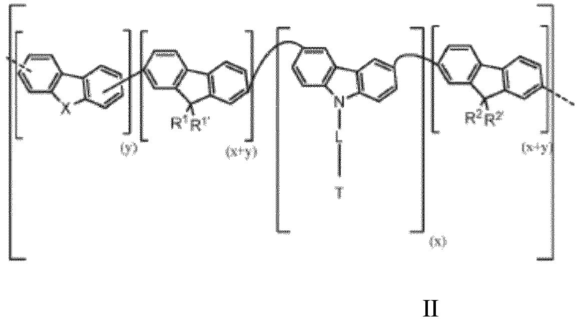 wherein
R¹ and R^{1'} are, independently from each other, a C₂-C₁₀ alkyl group;
R² and R^{2'} are, independently from each other, a C₂-C₁₀ alkyl group;
X is CR³R^{3'} or NR⁴;
R³ and R^{3'} are, independently from each other, a C₂-C₁₀ alkyl group;
R⁴ is a C₄-C₁₀ alkyl group;
x is between 0.01 and 0.50;
y is between 0 and 0.49, the sum of x+y being equal to 0.50.
L is a C₄-C₁₀ alkylene group;
T is a neutral bidentate Lewis base containing two coordinating nitrogen atoms.

11. Use of a metallopolymer according to any one of claims 1 to 9 for the manufacture of a light-emitting diode.

12. Light-emitting diode comprising a layer of a metallopolymer according to any one of claims 1 to 9.
